# EUROPEAN PATENT SPECIFICATION

(11) **EP 2 573 408 B1**
(45) Date of publication and mention of the grant of the patent: **17.05.2017**
(21) Application number: 12185709.8
(22) Date of filing: 24.09.2012
(51) Int. Cl.: F15B 13/08

(54) **Solenoid valve bypass system for continuous operation of pneumatic valve and method therefor**
Magnetventilbypasssystem zum kontinuierlichen Betrieb eines Druckluftventils und Verfahren dafür
Système de dérivation d'une soupape à solénoïde pour un fonctionnement continu de soupape pneumatique et procédé pour ce faire

(30) Priority: 26.09.2011 US 201113245280; 18.01.2012 US 201213352643
(43) Date of publication of application: 27.03.2013
(73) Proprietor: AIR PRODUCTS AND CHEMICALS, INC., Allentown, PA 18195-1501 (US)
(72) Inventor: Smith, Anthony John, New Tripoli, PA Pennsylvania 18066 (US); Barthold, Jeffery C., Walnutport, PA Pennsylvania 18088 (US); Dax, William John, Orefield, PA Pennsylvania 18069 (US)
(74) Representative: Beck Greener

(56) References cited:
- EP-A1- 0 391 269
- WO-A2-2008/143739
- US-B1- 6 269 834

## Description

### BACKGROUND OF THE INVENTION

The present invention relates generally to solenoid-operated valve devices for controlling industrial process systems, and more particularly to a system that allows for a continuous flow of industrial process gas through a valve while the electronic controller operating the valve not only is experiencing down time but is physically removed from the valve. A solenoid assembly according to the preamble of claim 1 is known from US 6,269,834 B1. Modern process or manufacturing plants contain innumerable operating components. These components are tied together to form systems controlled by instrumentation and control systems containing sensors and controllers. The instrumentation and control systems in such plants not only serve to control the functions of the various components in order to achieve the desired process conditions, but they also provide the facility to safely modify or discontinue the operation of all or a portion of the plant's systems in order to avoid an unsafe situation or condition.

For example, in a semiconductor manufacturing plant, gases/chemicals are handled by gas delivery equipment consisting of numerous valves and pressure sensors, with each delivery system controlled by a dedicated process control system (controller). The process delivery equipment supplies gas/chemical to a process tool where wafer fabrication is conducted through pneumatically operated valves. Such valves are operated by pneumatic actuators connected through solenoid operated pilot valves to the pneumatic control source.

In operation, the solenoid-operated valves of such systems serve to initiate a process whereby a fluid or pneumatic supply is either applied to or vented from the process valve actuator when one or more operatively associated solenoid-operated valves changes state or position in a predetermined manner, e.g., when the solenoid-operated valve is de-energized by the controller.

It takes a variety of different process tools and many processes steps involving the delivery of a variety of gases to ultimately create a semiconductor device layer-by-layer on a silicon wafer. As this process can take several days or weeks, depending on the complexity of the semiconductor device, the process tools preferably operate 24/7. This requires the gas delivery equipment supporting the process tools to supply a constant, uninterrupted flow of gas or chemical. An unscheduled interruption of a gas/chemical at the tool could result in a failed process step which may render useless the silicon wafers in-process at the time. The monetary value of this loss of silicon wafers can be significant, often listed in millions of dollars of lost revenue.

Thus, there exists a need for an apparatus and method to ensure a continuous flow of pressurized gas to the pneumatic valves in manufacturing processes when the controlling solenoid valves are de-energized for any reason, including failure and maintenance.

### BRIEF SUMMARY OF THE INVENTION

In a first aspect, there is provided a solenoid assembly for operating a plurality of pneumatic valves of a fluid delivery system and capable of supplying an uninterrupted flow of a fluid, the assembly comprising: a plurality of solenoid valves, wherein each solenoid valve is capable of being in an energized state and a de-energized state, each solenoid valve comprising: an internal pressure port in fluid communication with a first means to supply a pressurized inert gas; an internal actuator port in fluid communication with a respective pneumatic valve and with the internal pressure port when the solenoid is in an energized state; and an internal relief port in fluid communication with the internal actuator port when the solenoid valve is in a de-energized state; and a manifold upon which the plurality of solenoids is affixed, wherein the manifold is internally fluidly connected to each of the internal pressure inlet, the internal actuator port, and the internal relief port of each solenoid, and wherein the manifold comprises: an external pressure port in fluid communication with each internal pressure port of each solenoid valve; and a dedicated external relief port for each of the plurality of solenoid valves, wherein the dedicated external relief port is in fluid communication with the internal relief port of the respective solenoid valve such that, when one of the solenoid valves is de-energized, a second means to supply a pressurized inert gas can be connected to the external relief port and supply pressure to the respective pneumatic valve operated by that solenoid valve.

The solenoid assembly may further comprise flexible tubing connecting the external actuator port of each solenoid to a respective pneumatic valve.

In one embodiment, the pressurized inert gas is air. In one embodiment, the pressurized inert gas is nitrogen.

In one embodiment, the manifold comprises aluminum. In one embodiment, the manifold comprises stainless steel.

In a second aspect, the solenoid assembly further comprises: a first means to supply a pressurized inert gas; and a controller means for energizing and de-energizing each of the plurality of solenoids.

In a third aspect, there is provided a system for operating a plurality of pneumatic valves of a fluid delivery system and capable of supplying an uninterrupted flow of a fluid, the system comprising: a fluid system enclosure capable of housing at least one fluid delivery apparatus;a controller secured to but removable from the fluid system enclosure; a panel secured to and separable from the controller, the panel comprising a solenoid assembly according to the first aspect; and wherein the controller is capable of being removed away from the fluid system enclosure separate from the panel such that the panel remains on the fluid system.

In one embodiment, the panel comprises a steel plate and a gasket. In one embodiment, the controller comprises a mechanical pneumatic shut-off valve.

In a fourth aspect, there is provided a method for continuously operating a pneumatic valve delivering a fluid to a process tool via a solenoid valve assembly of the second aspect, the method comprising the steps of: a) supplying pressurized inert gas to the at least one external pressure port of the manifold; b) energizing at least one of the solenoid valves to allow the pressurized inert gas to flow through the internal pressure port of the at least one solenoid valve out through the external actuator port of the at least one solenoid valve to the respective pneumatic valve; c) connecting a second means to supply a pressurized inert gas to at least one of the dedicated external relief ports of the manifold; d) supplying the pressurized inert gas to the at least one of the dedicated external relief ports of the manifold; e) de-energizing the at least one energized solenoid valves to which the second means to supply a pressurized inert gas is connected via the dedicated external relief port; and f) supplying pressurized inert gas to the respective pneumatic valve operated by the de-energized solenoid valve from the dedicated external relief outlet through the external actuator port.

Additional aspects of the invention include the following aspects, numbered #1 to #26:
#1. A solenoid assembly for operating a plurality of pneumatic valves of a fluid delivery system and capable of supplying an uninterrupted flow of a fluid, the assembly comprising: a first means to supply a pressurized inert gas; a plurality of solenoid valves, wherein each solenoid valve is capable of being in an energized state and a de-energized state, each solenoid valve comprising: an internal pressure port in fluid communication with the first means to supply a pressurized inert gas; an internal actuator port in fluid communication with a respective pneumatic valve and with the internal pressure port when the solenoid is in an energized state; and an internal relief port in fluid communication with the internal actuator port when the solenoid valve is in a de-energized state; a manifold upon which the plurality of solenoids is affixed, wherein the manifold is internally fluidly connected to each of the internal pressure inlet, the internal actuator port, and the internal relief port of each solenoid, and wherein the manifold comprises: an external pressure port in fluid communication with each internal pressure port of each solenoid valve; and a dedicated external relief port for each of the plurality of solenoid valves, wherein the dedicated external relief port is in fluid communication with the internal relief port of the respective solenoid valve such that, when one of the solenoid valves is de-energized, a second means to supply a pressurized inert gas can be connected to the external relief port and supply pressure to the respective pneumatic valve operated by that solenoid valve; and a controller means for energizing and de-energizing each of the plurality of solenoids
.#2. The solenoid assembly of #1 further comprising flexible tubing connecting the external actuator port of each solenoid to a respective pneumatic valve.
#3. The solenoid assembly of #1 wherein the pressurized inert gas is air.
#4. The solenoid assembly of #1 wherein the pressurized inert gas is nitrogen.
#5. The solenoid assembly of #1 wherein the manifold comprises aluminum.
#6. The solenoid assembly of #1 wherein the manifold comprises stainless steel.
#7. A method for continuously operating a pneumatic valve delivering a fluid to a process tool via a solenoid valve assembly, the solenoid valve assembly comprising: a first means to supply a pressurized inert gas; a plurality of solenoid valves, wherein each solenoid valve is capable of being in an energized state and a de-energized state, each solenoid valve comprising: an internal pressure port in fluid communication with the first means to supply a pressurized inert gas; an internal actuator port in fluid communication with a respective pneumatic valve and with the internal pressure port when the solenoid is in an energized state; and an internal relief port in fluid communication with the internal actuator port when the solenoid valve is in a de-energized state; a manifold upon which the plurality of solenoids is affixed, wherein the manifold is internally fluidly connected to each of the internal pressure inlet, the internal actuator port, and the internal relief port of each solenoid, and wherein the manifold comprises: an external pressure port in fluid communication with each internal pressure port of each solenoid valve; and a dedicated external relief port for each of the plurality of solenoid valves, wherein the dedicated external relief port is in fluid communication with the internal relief port of the respective solenoid valve such that, when one of the solenoid valves is de-energized, a second means to supply a pressurized inert gas can be connected to the external relief port and supply pressure to the respective pneumatic valve operated by that solenoid valve; and a controller means for energizing and de-energizing each of the plurality of solenoids, the method comprising the steps of: a) supplying pressurized inert gas to the at least one external pressure port of the manifold; b) energizing at least one of the solenoid valves to allow the pressurized inert gas to flow through the internal pressure port of the at least one solenoid valve out through the external actuator port of the at least one solenoid valve to the respective pneumatic valve; c) connecting a second means to supply a pressurized inert gas to at least one of the dedicated external relief ports of the manifold; d) supplying the pressurized inert gas to the at least one of the dedicated external relief ports of the manifold; e) de-energizing the at least one energized solenoid valves to which the second means to supply a pressurized inert gas is connected via the dedicated external relief port; and f) supplying pressurized inert gas to the respective pneumatic valve operated by the de-energized solenoid valve from the dedicated external relief outlet through the external actuator port.
#8. The solenoid assembly of #7 further comprising flexible tubing connecting the external actuator port of each solenoid to a respective pneumatic valve.
#9. The solenoid assembly of #7 wherein the pressurized inert gas is air.
#10. The solenoid assembly of #7 wherein the pressurized inert gas is nitrogen.
#11. The solenoid assembly of #7 wherein the manifold comprises aluminum.
#12. The solenoid assembly of #7 wherein the manifold comprises stainless steel.
#13. A solenoid assembly for operating a plurality of pneumatic valves of a fluid delivery system and capable of supplying an uninterrupted flow of a fluid, the assembly comprising:a plurality of solenoid valves, wherein each solenoid valve is capable of being in an energized state and a de-energized state, each solenoid valve comprising:an internal pressure port in fluid communication with a first means to supply a pressurized inert gas;an internal actuator port in fluid communication with a respective pneumatic valve and with the internal pressure port when the solenoid is in an energized state; and an internal relief port in fluid communication with the internal actuator port when the solenoid valve is in a de-energized state; and a manifold upon which the plurality of solenoids is affixed, wherein the manifold is internally fluidly connected to each of the internal pressure inlet, the internal actuator port, and the internal relief port of each solenoid, and wherein the manifold comprises: an external pressure port in fluid communication with each internal pressure port of each solenoid valve; and a dedicated external relief port for each of the plurality of solenoid valves, wherein the dedicated external relief port is in fluid communication with the internal relief port of the respective solenoid valve such that, when one of the solenoid valves is de-energized, a second means to supply a pressurized inert gas can be connected to the external relief port and supply pressure to the respective pneumatic valve operated by that solenoid valve.
#14. The solenoid assembly of #13 further comprising flexible tubing connecting the external actuator port of each solenoid to a respective pneumatic valve.
#15. The solenoid assembly of #13 wherein the pressurized inert gas is air.
#16. The solenoid assembly of #13 wherein the pressurized inert gas is nitrogen.
#17. The solenoid assembly of #13 wherein the manifold comprises aluminum.
#18. The solenoid assembly of #13 wherein the manifold comprises stainless steel.
#19. A system for operating a plurality of pneumatic valves of a fluid delivery system and capable of supplying an uninterrupted flow of a fluid, the system comprising: a fluid system enclosure capable of housing at least one fluid delivery apparatus;a controller secured to but removable from the fluid system enclosure; a panel secured to and separable from the controller, the panel comprising: a plurality of solenoid valves, wherein each solenoid valve is capable of being in an energized state and a de-energized state, each solenoid valve comprising:an internal pressure port in fluid communication with a first means to supply a pressurized inert gas;an internal actuator port in fluid communication with a respective pneumatic valve and with the internal pressure port when the solenoid is in an energized state; and an internal relief port in fluid communication with the internal actuator port when the solenoid valve is in a de-energized state; and a manifold upon which the plurality of solenoids is affixed, wherein the manifold is internally fluidly connected to each of the internal pressure inlet, the internal actuator port, and the internal relief port of each solenoid, and wherein the manifold comprises:an external pressure port in fluid communication with each internal pressure port of each solenoid valve; and a dedicated external relief port for each of the plurality of solenoid valves, wherein the dedicated external relief port is in fluid communication with the internal relief port of the respective solenoid valve such that, when one of the solenoid valves is de-energized, a second means to supply a pressurized inert gas can be connected to the external relief port and supply pressure to the respective pneumatic valve operated by that solenoid valve,wherein the controller is capable of being removed away from the fluid system enclosure separate from the panel such that the panel remains on the fluid system.
#20. The system of #19 wherein the solenoid assembly further comprises flexible tubing connecting the external actuator port of each solenoid to a respective pneumatic valve.
#21. The system of #19 wherein the pressurized inert gas is air.
#22. The system of #19 wherein the pressurized inert gas is nitrogen.
#23. The system of #19 wherein the manifold comprises aluminum.
#24. The system of #19 wherein the manifold comprises stainless steel.
#25. The system of #19 wherein the panel comprises a steel plate and a gasket.
#26. The system of #19 wherein the controller comprises a mechanical pneumatic shut-off valve.

Other aspects, features and embodiments of the invention will be more fully apparent from the ensuing disclosure and appended claims.

### BRIEF DESCRIPTION OF SEVERAL VIEWS OF THE DRAWINGS

FIG. 1 is a perspective view of a prior art solenoid assembly.
FIG. 2 is a perspective view of one embodiment of the solenoid assembly of the present invention.
FIG. 3 is a cross-sectional view of the solenoid valve assembly according to an embodiment of the present invention wherein the solenoid valve is in an energized state.
FIG. 4 is the cross-sectional view of the solenoid valve assembly shown in FIG. 3 wherein the solenoid valve is in a de-energized state.
FIG. 5 is a perspective view of the system of an embodiment of the present invention.
FIG. 6 is another perspective view of the system of an embodiment of the present invention.

### DETAILED DESCRIPTION OF THE INVENTION

Referring to the figures set forth in the accompanying Drawings, the illustrative embodiments of the present invention will be described in detail herein below. For clarity of exposition, like features shown in the accompanying Drawings shall be indicated with like reference numerals and similar features as shown in alternate embodiments in the Drawings shall be indicated with similar reference numerals.

In embodiments, the present invention relates to a solenoid assembly for operating a plurality of pneumatic valves of a fluid delivery system and capable of supplying an uninterrupted flow of a fluid. As used herein, the term "uninterrupted" or "continuous" as it refers to the operation of an industrial process tool means that the process tool does not experience significant down time or delay that would render the tool inoperable or would cause the failure of the process step employing the tool. As used herein, the term "fluid" means a liquid, a gas, or a gaseous chemical reagent.

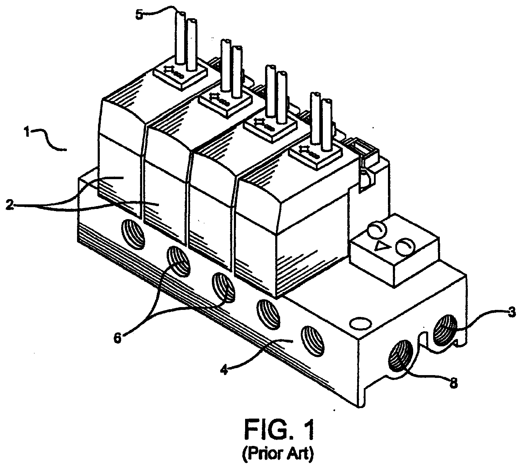

FIG. 1 illustrates an example of a typical prior art solenoid assembly **1** for the operation of, for example, a pneumatic valve on an industrial gas handling equipment such as, for example, a gas cabinet delivering a gaseous chemical to a semiconductor process tool. Prior art solenoid assembly **1** is electrically controlled by a dedicated process control system comprising sensors and a microprocessor (not shown) via wires **5.** Prior art solenoid assembly **1** comprises multiple solenoid valves **2** secured to manifold **4,** which provides internal connections to pneumatic ports (not shown) in each solenoid valve **2.** Each of solenoid valves **2** controls a respective pneumatic valve that, in turn, delivers a gas or a gaseous chemical to a process tool. Manifold **4** comprises external actuator ports **6** (one dedicated to each solenoid valve **2**) (fittings not shown), external pressure port **3** (fittings not shown), and external relief port **8** (fittings not shown). A pressurized inert gas such as, for example, air or nitrogen, is introduced via external pressure port **3** to supply each of the solenoid valves **2** with pressurized inert gas such that, when energized, each of the solenoid valves **2** will supply the pressurized inert gas to a respective pneumatic valve (not shown) via flexible tubing (not shown) through the external actuator ports **6.** Once de-energized, pressurized inert gas is exhausted from the solenoid valves **2** via external relief port **8.** External pressure port **3** and external relief port **8** run the length of the manifold **4** and are in fluid communication with each of the solenoid valves **2.** In this configuration, if the controller becomes inoperable and needs to be repaired then the entire manifold needs to be shut down and, thus, all of the tools operated by the solenoid valves would be shut down causing an interruption in the manufacturing process and, potentially, a failed process step resulting in the loss of revenue.

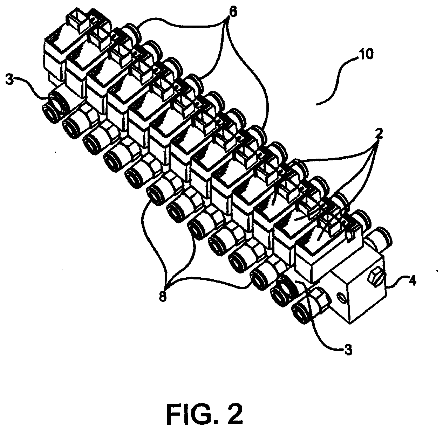

FIG. 2 is a perspective view of the solenoid assembly **10** of one embodiment of the present invention. Solenoid assembly **10** comprises a plurality of solenoid valves **2,** wherein each solenoid valve **2** is capable of being in an energized state and a de-energized state. Like that of FIG. 1, each of solenoid valves **2** controls a pneumatic valve that, in turn, delivers a gas or a gaseous chemical to an industrial process tool such as, for example, a process tool employed during a step in the manufacturing process of a semiconductor on a silicon wafer. Any solenoid known to those of ordinary skill in the art can be employed in the present invention. One example of a suitable solenoid valve for use in the present invention is a V100 Series three-port solenoid valve commercially available from SMC Corporation of America (Noblesville, IN).

Each solenoid valve **2** comprises an internal pressure port (not shown) in fluid communication with a first means to supply a pressurized inert gas (not shown). The first means to supply a pressurized inert gas can be, for example, a pneumatic pressure line connected to, for example, a pressurized cylinder or a house air or N₂ line. Each solenoid valve **2** also comprises an internal actuator port (not shown) in fluid communication with a respective pneumatic valve (not shown) and with the internal pressure port when the solenoid is in an energized state. Each solenoid valve **2** of the solenoid assembly **10** also comprises an internal relief port (not shown) in fluid communication with the internal actuator port when the solenoid valve is in a de-energized state.

Still referring to FIG. 2, solenoid valve assembly **10** comprises a manifold **4** to which each solenoid valve **2** is affixed. The manifold **4** is internally fluidly connected to each of the internal pressure port, the internal actuator port, and the internal relief port of each solenoid. Manifold **4** comprises external actuator ports **6** (one dedicated to each solenoid valve **2**) through which pressurized inert gas will flow to a respective pneumatic valve (not shown) via flexible tubing (not shown).

Manifold **4** also comprises at least one external pressure port **3.** External pressure port **3** runs the length of manifold **4** and is in fluid communication (internally) with each internal pressure port of each solenoid valve to supply pressurized inert gas to the solenoid valves **2.** Manifold **4** may have more than one external pressure port **3** for serial connection with another solenoid valve assembly. Where no additional serial connections are required, one of the external pressure ports can be fitted with a plug so as to maintain the internal pressure to the solenoid valves. Manifold **4** can be made from any material suitable for the required operating pressure. A typical operating pressure is from about 50 psi to about 100 psi and, preferably, from about 70 psi to about 80 psi. Metal is a preferred material for manifold **4** and aluminum and stainless steel are examples of preferred metals.

Manifold **4** also comprises a dedicated external relief port **8** for each of the plurality of solenoids **2** wherein the external relief port **8** is in fluid communication with the internal relief port of the respective solenoid valve **2.** As used herein, the term "dedicated external relief port" means that each solenoid valve **2** has its own relief port in fluid communication with the internal actuator port when the solenoid valve is in a de-energized state as opposed to, for example, that shown in prior art FIG. 1, where an external relief port being in fluid communication with more than one solenoid valve. With this configuration, when one of the solenoid valves **2** is de-energized, a second means to supply a pressurized inert gas can be connected to the external relief port **8** and supply pressure to the respective pneumatic valve operated by that solenoid valve **2,** thus by-passing the external pressure port **3** and the need to energize the respective solenoid valve **2.**

The second means to supply a pressurized inert gas can be, for example, a pneumatic pressure line connected to, for example, a pressurized cylinder or a house air or N₂ line and may be the same as the first means or may be a separate line connected to the same supply cylinder or source of house air or nitrogen. The role of the second means will be described in further detail in the following paragraphs.

Solenoid valve assembly **10** also comprises a controller means (not shown) for electrically energizing and de-energizing each of the plurality of solenoids. The controller means preferably comprises a logic microprocessor and sensors and may be any controller means familiar to those skilled in the art.

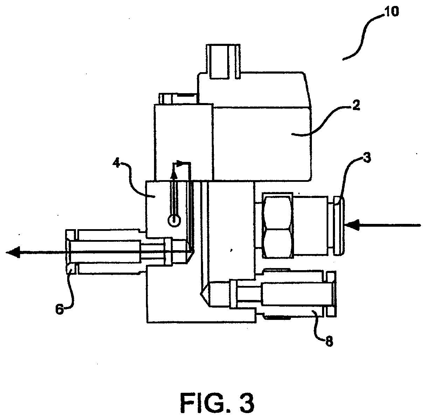

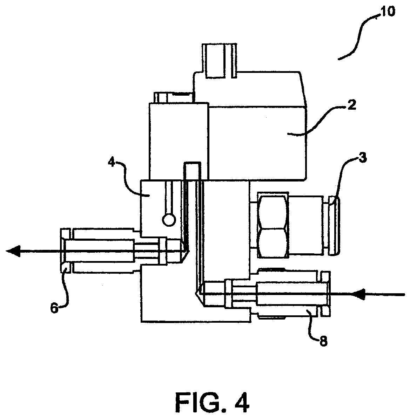

FIGS. 3 and 4 illustrate the operation of the solenoid valve assembly **10** of the present invention. Referring to FIG. 3, a cross-sectional view of the solenoid valve assembly **10** is shown wherein the solenoid valve **2** is in an energized state as instructed by the controller (not shown). Pressurized inert gas such as, for example, air, is introduced into the manifold **4** at external pressure port **3.** In an energized state, solenoid valve **2** permits internal fluid communication between the external pressure port **3** and the external actuator port **6** through which the pressurized air flows to safely operate a respective pneumatic valve (not shown) via flexible tubing (not shown).

FIG. 4 illustrates the solenoid valve assembly of FIG. 3 wherein the solenoid valve **2** is in a de-energized state. Solenoid valve **2,** for example, may be the only solenoid valve **2** or one of several in the assembly **10** that is de-energized due to a variety of reasons such as, for example, controller failure or routine maintenance. When gas flow to the pneumatic valve needs to be maintained, a pneumatic pressure line can be connected to solenoid valve **2** (or any other solenoid valves **2** that require the bypass) via the dedicated external relief port **8.** Air pressure, for example, is then supplied to each dedicated external relief port **8,** which currently is not in fluid communication with the external actuator port **6** when the solenoid valve **2** is in a energized state as is shown via the arrows in FIG.3. Once the solenoid has been by-passed, the controller can be powered off or placed in an idle state, the solenoid valve de-energizes instantly causing the air flow to shift from the external pressure port **3** to the dedicated external relief port **8.** As a result of the operation of the present invention, the pneumatic valves in the delivery path do not experience a loss of pneumatic pressure and continue to allow the flow of gas or gaseous chemical while the controller (and, thus, the particular solenoid valve(s) **2**) is powered down to allow for maintenance of the controller or the solenoid valve(s) **2.** Thus, the solenoid valve assembly of the present invention permits selective solenoid valve by-passing to ensure continuous operation of the process tools.

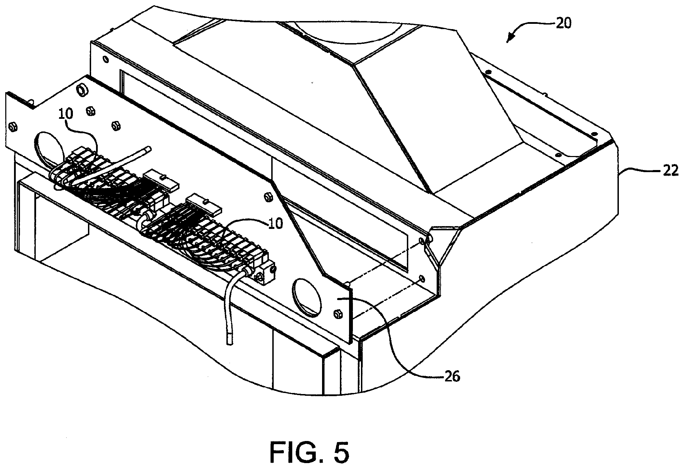

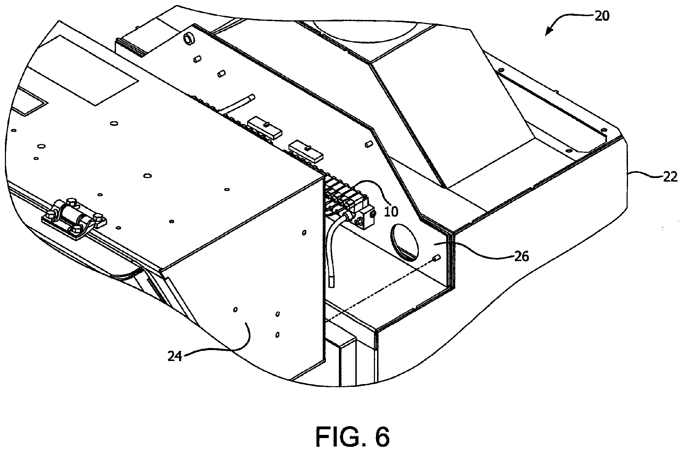

In another embodiment of the present invention, a system is provided for operating a plurality of pneumatic valves of a fluid delivery system and capable of supplying an uninterrupted flow of a fluid. Referring to FIGS. 5 and 6, the system **20** comprises a fluid system enclosure **22** capable of housing at least one fluid delivery apparatus (not shown). The function of the fluid system enclosure **22** is to ensure a safe environment for personnel during cylinder changes or in the event of a hazardous gas leak. The fluid system enclosure **22** must be connected to a properly designed exhaust system that is continuously operated in order to provide a safe environment. The fluid system enclosure **22** provides the secondary containment for any leak from the hazardous gas cylinder, cylinder connection and pigtail, and the process panel. The exhaust system continuously removes any leaking hazardous gas from the fluid system enclosure to a safe disposal system.

The fluid system enclosure **22** is preferably constructed of 12 gage (0.004 mm) steel with fully welded seams and protected with corrosion resistant polyurethane paint. The fluid system enclosure **22** is preferably large enough to hold from one to three cylinders. One or more exhaust stacks are typically provided for connection to an exhaust system. Preferably, the fluid system enclosure **22** has 12 gage (0.004 mm) steel doors with windows constructed of 1/4" thick (6.4 mm) wire reinforced safety glass.

A temperature activated (165°F /74°C) sprinkler head may also be provided. Preferably, formed brackets are mounted inside of the cabinet to securely hold each cylinder contained therein. An example of a fluid system enclosure for use in accordance with the present invention is the AP11 GASGUARD™ commercially available from Air Products and Chemicals, Inc. (Allentown, PA).

The fluid delivery system can comprise canisters or cylinders of harmful process gasses for delivery to a tool. Exemplary gases include process gases employed in the manufacture of microelectronics such as, for example, ammonia, hydrogen chloride, boron trichloride, hydrogen fluoride, boron trifluoride, hydrogen sulfide, chlorine, nitrogen dioxide, chlorine trifluoride, phosphorous pentafluoride, dichlorosilane, silicon tetrachloride, fluorine, silicon tetrafluoride, hydrogen bromide, and tungsten hexafluoride.

Referring to FIG. 6, the system of the present invention further comprises a controller **24.** Controller **24** is preferably a microprocessor-based unit housed in a metal enclosure. Controller **24** functions to continuously monitor system inputs and automatically perform purging operations by sequencing valve actuation. Adequate purging is ensured by checking pressure and vacuum at each step within the purge cycles. Controller **24** preferably also has the capability of shutting down the system if an unsafe condition arises. Controller **24** preferably comprises a screen (not shown) that allows the operator to easily understand the operation and to quickly identify operating problems as well as a color scheme showing open and closed valves. Preferably, controller **24** also comprises a shutdown alarm box and/or an emergency shut-off valve (mechanical/ pneumatic). Such controllers are also exemplified by the AP11 GASGUARD™ commercially available from Air Products and Chemicals, Inc. (Allentown, PA).

Referring again to FIGS. 5 and 6, system **20** of an embodiment of the present invention comprises panel **26** comprising at least one solenoid valve assembly **10** according to the present invention and detailed above. Panel **26** may be made from any suitable material although aluminum or stainless steel are preferred. Panel **26** preferably comprises a gasket around its perimeter to better seal off the electronics inside of controller **24** from the ambient environment in the event that hazardous material becomes uncontained.

Panel **26** is secured to and separable from the controller **24.** Panel **26** is also secured to fluid system enclosure **22.** Panel **26** may be secured to controller **24** and fluid system enclosure **22** by any means known to those skilled in the art, including screws, bolts, or other fastening means, which will allow for repeated separation and attachment of panel **26** to controller **24** and/or the fluid system enclosure **22.** As used herein, the term "separable" as it relates to panel **26** means that panel **26** is able to be separated from the controller **24** such that controller **24** can be removed away from fluid system enclosure **22** without removing the solenoid valve assembly **10** according to the present invention away from the fluid system enclosure **22,** which will allow the bypass so the pneumatic valves in the delivery path to not experience a loss of pneumatic pressure and continue to allow the flow of gas or gaseous chemical while the controller (and, thus, the particular solenoid valve(s)) is completely removed for maintenance or replacement with a new controller and associated electronics.

With this configuration, to manually and pneumatically bypass the solenoids, a single pneumatic tube (i.e., the a second means to supply a pressurized inert gas) (not shown) can be fed into the controller via a plugged connection on a solenoid assembly. Pneumatic tees can then be employed on this tube within the controller and connected to the specific solenoids required to enable continuing gas flow. Once connected to the correct solenoids, pressure is applied to the in-coming tube. The controller can now be de-energized which will also de-energize the solenoids. The solenoids which are pneumatically by-passed will remain open. The controller can then be physically removed if necessary, leaving the panel **26** attached to the gas system enclosure **22.**

Once controller maintenance is complete or a new controller is installed, the pneumatically by-passed solenoids can be returned to normal controller functionality and the temporary pneumatic tubing removed.

In view of this description of the operation of the solenoid valve assembly 10 of the present invention, an embodiment of the present invention also provides a method for continuously operating a pneumatic valve delivering a fluid to a process tool via a solenoid valve assembly. The method comprises the steps of supplying pressurized inert gas to the at least one external pressure port of the manifold; energizing at least one of the solenoid valves to allow the pressurized inert gas to flow through the internal pressure port of the at least one solenoid valve out through the external actuator port of the at least one solenoid valve to the respective pneumatic valve; connecting a second means to supply a pressurized inert gas to at least one of the dedicated external relief ports of the manifold; supplying the pressurized inert gas to the at least one of the dedicated external relief ports of the manifold; de-energizing the at least one energized solenoid valves to which the second means to supply a pressurized inert gas is connected via the dedicated external relief port; and supplying pressurized inert gas to the respective pneumatic valve operated by the de-energized solenoid valve from the dedicated external relief outlet through the external actuator port.

The foregoing description is intended primarily for purposes of illustration. Although the invention has been shown and described with respect to an exemplary embodiment thereof, it should be understood by those skilled in the art that the foregoing and various other changes, omissions, and additions in the form and detail thereof may be made therein without departing from the scope of the present invention as defined by the appended claims.

## Claims

1. A solenoid assembly (10) for operating a plurality of pneumatic valves of a fluid delivery system and capable of supplying an uninterrupted flow of a fluid, the assembly comprising:
a plurality of solenoid valves (2), wherein each solenoid valve is capable of being in an energized state and a de-energized state, each solenoid valve comprising:
an internal pressure port in fluid communication with a first means to supply a pressurized inert gas;
an internal actuator port in fluid communication with a respective pneumatic valve and with the internal pressure port when the solenoid valve is in an energized state; and
an internal relief port in fluid communication with the internal actuator port when the solenoid valve is in a de-energized state; and
a manifold (4) upon which the plurality of solenoid valves is affixed, **characterised in that** the manifold is internally fluidly connected to each of the internal pressure port, the internal actuator port, and the internal relief port of each solenoid valve, and wherein the manifold comprises:
an external pressure port (3) in fluid communication with each internal pressure port of each solenoid valve; and
a dedicated external relief port (8) for each of the plurality of solenoid valves, wherein the dedicated external relief port is in fluid communication with the internal relief port of the respective solenoid valve such that, when one of the solenoid valves is de-energized, a second means to supply a pressurized inert gas can be connected to the external relief port and supply pressure to the respective pneumatic valve operated by that solenoid valve.

2. The solenoid assembly of claim 1 further comprising flexible tubing connecting the external actuator port of each solenoid valve to a respective pneumatic valve.

3. The solenoid assembly of claim 1 or 2 wherein the pressurized inert gas is air.

4. The solenoid assembly of claim 1 or 2 wherein the pressurized inert gas is nitrogen.

5. The solenoid assembly of any one of the preceding claims wherein the manifold comprises aluminum.

6. The solenoid assembly of any one of claims 1 to 4 wherein the manifold comprises stainless steel.

7. The solenoid assembly of any one of claims 1 to 6, further comprising:
a first means to supply a pressurized inert gas; and
a controller means for energizing and de-energizing each of the plurality of solenoid valves.

8. A system for operating a plurality of pneumatic valves of a fluid delivery system and capable of supplying an uninterrupted flow of a fluid, the system comprising:
a fluid system enclosure (22) capable of housing at least one fluid delivery apparatus;
a controller (24) secured to but removable from the fluid system enclosure;
a panel (26) secured to and separable from the controller, the panel comprising a solenoid assembly according to any one of claims 1 to 6; and:
wherein the controller is capable of being removed away from the fluid system enclosure separate from the panel such that the panel remains on the fluid system enclosure.

9. The system of claim 8 wherein the panel comprises a steel plate and a gasket.

10. The system of claim 8 or 9 wherein the controller comprises a mechanical pneumatic shut-off valve.

11. A method for continuously operating a pneumatic valve delivering a fluid to a process tool via a solenoid assembly (10) of claim 7, the method comprising the steps of:
a) supplying pressurized inert gas to the at least one external pressure port (3) of the manifold (4);
b) energizing at least one of the solenoid valves (2) to allow the pressurized inert gas to flow through the internal pressure port of the at least one solenoid valve out through the external actuator port (6) of the at least one solenoid valve to the respective pneumatic valve;
c) connecting a second means to supply a pressurized inert gas to at least one of the dedicated external relief ports (8) of the manifold;
d) supplying the pressurized inert gas to the at least one of the dedicated external relief ports of the manifold;
e) de-energizing the at least one energized solenoid valves to which the second means to supply a pressurized inert gas is connected via the dedicated external relief port; and
f) supplying pressurized inert gas to the respective pneumatic valve operated by the de-energized solenoid valve from the dedicated external relief outlet through the external actuator port.

## Patentansprüche

1. Solenoidanordnung (10) zum Betreiben von einer Vielzahl von pneumatischen Ventilen von einem Fluidliefersystem, und die in der Lage ist, eine ununterbrochene Strömung von einem Fluid zuzuführen, wobei die Anordnung das Folgende umfasst:
eine Vielzahl von Solenoidventilen (2), wobei jedes Solenoidventil in der Lage ist, sich in einem spannungsangelegten Zustand und einem spannungsentfernten Zustand zu befinden, wobei jedes Solenoidventil das Folgende umfasst:
eine internen Druckanschluss, die mit einem ersten Mittel zum Zuführen von einem unter Druck gesetzten Inertgas in Fluidkommunikation steht;
einen internen Aktuatoranschluss, der mit einem entsprechenden pneumatischen Ventil und dem internen Druckanschluss in Fluidkommunikation steht, wenn sich das Solenoidventil in einem spannungsangelegten Zustand befindet; und
einen internen Entlastungsanschluss, der mit dem internen Aktuatoranschluss in Fluidkommunikation steht, wenn sich das Solenoidventil in einem spannungsentfernten Zustand befindet; und
einen Verteiler (4), auf dem die Vielzahl von Solenoidventilen befestigt ist, **dadurch gekennzeichnet, dass**
der Verteiler mit jedem von dem internen Druckanschluss, dem internen Aktuatoranschluss und dem internen Entlastungsanschluss jedes Solenoidventils intern in Fluidverbindung verbunden ist, und wobei der Verteiler das Folgende umfasst:
einen externen Druckanschluss (3), der mit jedem internen Druckanschluss von jedem Solenoidventil in Fluidkommunikation steht; und
einen zugeordneten externen Entlastungsanschluss (8) für jedes von der Vielzahl von Solenoidventilen, wobei der zugeordnete externe Entlastungsanschluss mit dem internen Entlastungsanschluss des entsprechenden Solenoidventils in Fluidkommunikation steht, so dass, wenn an einem der Solenoidventile die Spannung entfernt wird, ein zweites Mittel zum Zuführen von einem unter Druck gesetzten Inertgas an dem externen Entlastungsanschluss angeschlossen werden kann und dieses dem entsprechenden pneumatischen Ventil, das durch dieses Solenoidventil betrieben wird, Druck zuführen kann.

2. Solenoidanordnung nach Anspruch 1, ferner umfassend eine flexible Verschlauchung, die den externen Aktuatoranschluss von jedem Solenoidventil mit einem entsprechenden pneumatischen Ventil verbindet.

3. Solenoidanordnung nach Anspruch 1 oder 2, wobei das unter Druck gesetzte Inertgas Luft ist.

4. Solenoidanordnung nach Anspruch 1 oder 2, wobei das unter Druck gesetzte Inertgas Stickstoff ist.

5. Solenoidanordnung nach einem der vorhergehenden Ansprüche, wobei der Verteiler Aluminium umfasst.

6. Solenoidanordnung nach einem der Ansprüche 1 bis 4, wobei der Verteiler Edelstahl umfasst.

7. Solenoidanordnung nach einem der Ansprüche 1 bis 6, ferner umfassend:
ein erstes Mittel zum Zuführen von einem unter Druck gesetzten Inertgas; und
ein Steuermittel, um an jedem von der Vielzahl von Solenoidventilen eine Spannung anzulegen oder zu entfernen.

8. System zum Betreiben von einer Vielzahl von pneumatischen Ventilen von einem Fluidliefersystem und das in der Lage ist, eine ununterbrochene Strömung von einem Fluid zuzuführen, wobei das System das Folgende umfasst:
ein Fluidsystemgehäuse (22), das in der Lage ist, mindestens einen Fluidlieferapparat unterzubringen;
ein Steuergerät (24), das an dem Fluidsystemgehäuse entfernbar gesichert ist;
eine Tafel (26), die an dem Steuergerät gesichert und von diesem entfernbar ist, wobei die Tafel eine Solenoidanordnung nach einem der Ansprüche 1 bis 6 umfasst; und:
wobei das Steuergerät in der Lage ist, von dem Fluidsystemgehäuse entfernt zu werden, und zwar getrennt von der Tafel, so dass die Tafel an dem Fluidsystemgehäuse verbleibt.

9. System nach Anspruch 8, wobei die Tafel eine Stahlplatte und eine Dichtung umfasst.

10. System nach Anspruch 8 oder 9, wobei das Steuergerät ein mechanisches pneumatisches Absperrventil umfasst.

11. Verfahren zum kontinuierlichen Betreiben von einem pneumatischen Ventil, welches ein Fluid über die Solenoidanordnung (10) nach Anspruch 7 an Prozesshilfsmittel liefert, wobei das Verfahren die folgenden Schritte umfasst:
a) Zuführen von unter Druck gesetztem Inertgas zu dem mindestens einen externen Druckanschluss (3) des Verteilers (4);
b) Anlegen von einer Spannung an mindestens einem der Solenoidventile (2), um es dem unter Druck gesetzten Inertgas zu ermöglichen, durch den internen Druckanschluss von dem mindestens einen Solenoidventil hinaus durch den externen Aktuatoranschluss (6) von dem mindestens einen Solenoidventil zu dem entsprechenden pneumatischen Ventil zu strömen;
c) Verbinden von einem zweiten Mittel, um zu mindestens einem von den zugeordneten externen Entlastungsanschlüssen (8) des Verteilers ein unter Druck gesetztes Inertgas zuzuführen;
d) Zuführen von dem unter Druck gesetzten Inertgas zu dem mindestens einen von den zugeordneten Entlastungsanschlüssen des Verteilers;
e) Entfernen von der Spannung von dem mindestens einen spannungsangelegten Solenoidventil, mit dem das zweite Mittel zum Zuführen von einem unter Druck gesetztem Inertgas über den zugeordneten externen Entlastungsanschluss verbunden ist; und
f) Zuführen von unter Druck gesetztem Inertgas zu dem entsprechenden pneumatischen Ventil, welches durch das spannungsentfernte Solenoidventil betrieben wird, aus dem zugeordneten externen Entlastungsanschluss durch den externen Aktuatoranschuss.

## Revendications

1. Ensemble de solénoïde (10) pour l'actionnement d'une pluralité de soupapes pneumatiques d'un système de fourniture de fluide et apte à fournir un flux ininterrompu d'un fluide, l'ensemble comprenant :
une pluralité de soupapes à solénoïde (2), dans lequel chaque soupape à solénoïde est apte à être dans un état activé et un état désactivé, chaque soupape à solénoïde comprenant :
un orifice de pression interne en communication fluidique avec un premier moyen pour fournir un gaz inerte pressurisé ;
un orifice d'actionneur interne en communication fluidique avec une soupape pneumatique respective et avec l'orifice de pression interne lorsque la soupape à solénoïde est dans un état activé ; et
un orifice de décharge interne en communication fluidique avec l'orifice d'actionneur interne lorsque la soupape à solénoïde est dans un état désactivé ; et
un collecteur (4), sur lequel la pluralité de soupapes à solénoïde est fixée, **caractérisé en ce que** le collecteur est relié en interne fluidiquement à chacun de l'orifice de pression interne, l'orifice d'actionneur interne et l'orifice de décharge interne de chaque soupape à solénoïde, et dans lequel le collecteur comprend :
un orifice de pression externe (3) en communication fluidique avec chaque orifice de pression interne de chaque soupape à solénoïde ; et
un orifice de décharge externe dédié (8) pour chacun de la pluralité de soupapes à solénoïde, dans lequel l'orifice de décharge externe dédié est en communication fluidique avec l'orifice de décharge interne de la soupape à solénoïde respective de sorte que lorsqu'une des soupapes à solénoïde est désactivée, un second moyen pour fournir un gaz inerte pressurisé peut être relié à l'orifice de décharge externe et fournir la pression à la soupape pneumatique respective actionnée par cette soupape à solénoïde.

2. Ensemble de solénoïde selon la revendication 1, comprenant en outre un tubage flexible reliant l'orifice d'actionneur externe de chaque soupape à solénoïde à une soupape pneumatique respective.

3. Ensemble de solénoïde selon la revendication 1 ou 2, dans lequel le gaz inerte pressurisé est de l'air.

4. Ensemble de solénoïde selon la revendication 1 ou 2, dans lequel le gaz inerte pressurisé est de l'azote.

5. Ensemble de solénoïde selon l'une quelconque des revendications précédentes, dans lequel le collecteur comprend de l'aluminium.

6. Ensemble de solénoïde selon l'une quelconque des revendications 1 à 4, dans lequel le collecteur comprend de l'acier inoxydable.

7. Ensemble de solénoïde selon l'une quelconque des revendications 1 à 6, comprenant en outre :
un premier moyen pour fournir un gaz inerte pressurisé ; et
un moyen de commande pour activer et désactiver chacune de la pluralité de soupapes à solénoïde.

8. Système d'actionnement d'une pluralité de soupapes pneumatiques d'un système de fourniture de fluide et apte à fournir un flux ininterrompu d'un fluide, le système comprenant :
une enceinte de système de fluide (22) apte à loger au moins un appareil de fourniture de fluide ;
un dispositif de commande (24) fixé à l'enceinte de système de fluide mais amovible de celle-ci ;
un panneau (26) fixé au dispositif de commande et séparable de celui-ci, le panneau comprenant un ensemble de solénoïde selon l'une quelconque des revendications 1 à 6 ; et
dans lequel le dispositif de commande est apte à être retiré à l'écart de l'enceinte de système de fluide séparément du panneau de sorte que le panneau reste sur l'enceinte de système de fluide.

9. Système selon la revendication 8, dans lequel le panneau comprend une plaque d'acier et un joint.

10. Système selon la revendication 8 ou 9, dans lequel le dispositif de commande comprend une soupape d'arrêt pneumatique mécanique.

11. Procédé d'actionnement continu d'une soupape pneumatique fournissant un fluide à un outil de processus par le biais d'un ensemble de solénoïde (10) selon la revendication 7, le procédé comprenant les étapes de :
a) la fourniture du gaz inerte pressurisé à l'au moins un orifice de pression externe (3) du collecteur (4) ;
b) l'activation d'au moins une des soupapes à solénoïde (2) pour permettre au gaz inerte pressurisé de s'écouler à travers l'orifice de pression interne de l'au moins une soupape à solénoïde à travers l'orifice d'actionneur externe (6) de l'au moins une soupape à solénoïde à la soupape pneumatique respective ;
c) la liaison d'un second moyen pour fournir un gaz inerte pressurisé à au moins un des orifices de décharge externes dédiés (8) du collecteur ;
d) la fourniture du gaz inerte pressurisé à l'au moins un des orifices de décharge externes dédiés du collecteur ;
e) la désactivation de l'au moins une soupape à solénoïde activée, à laquelle le second moyen pour fournir un gaz inerte pressurisé est relié par le biais de l'orifice de décharge externe dédié ; et
f) la fourniture du gaz inerte pressurisé à la soupape pneumatique respective actionnée par la soupape à solénoïde désactivée depuis la sortie de décharge externe dédiée à travers l'orifice d'actionneur externe.
